# EUROPEAN PATENT APPLICATION

(11) **EP 4 358 160 A1**
(43) Date of publication of application: **24.04.2024**
(21) Application number: 23798324.2
(22) Date of filing: 29.08.2023
(51) Int. Cl.: H01L 31/18, H01L 31/0216, H01L 31/048

(54) **PREPARATION METHOD FOR PHOTOVOLTAIC MODULE, AND PHOTOVOLTAIC MODULE**

(30) Priority: 05.09.2022 CN 202211075516
(71) Applicant: Jinko Solar (Haining) Co., Ltd., Haining City, Zhejiang 314415 (CN)
(72) Inventor: HUANG, Shiliang, Jiaxing Zhejiang 314415 (CN); GUO, Zhiqiu, Jiaxing Zhejiang 314415 (CN); GUAN, Yingli, Jiaxing Zhejiang 314415 (CN); YANG, Jingguo, Jiaxing Zhejiang 314415 (CN)
(74) Representative: Müller Schupfner & Partner Patent- und Rechtsanwaltspartnerschaft mbB
(86) International application number: PCT/CN2023/115390
(87) International publication number: WO 2024/051519

(57) **Abstract**

The present disclosure relates to a method for manufacturing a photovoltaic module and a photovoltaic module. The method includes: providing a front packaging structure, a photovoltaic cell, and a back sheet, the front packaging structure including a cover plate and a packaging layer; forming an insulating layer and forming through holes on a surface of at least one side of the photovoltaic cell, so that positions of the through holes correspond to electrode lines of the photovoltaic cell; forming a conductive layer on the back sheet; applying a conductive adhesive in the through holes and/or on the conductive layer; connecting the back sheet to the photovoltaic cell so that the insulating layer fits the conductive layer and the conductive adhesive electrically connects the electrode lines and the conductive layer through the through holes; forming the packaging layer on a side of the photovoltaic cell away from the back sheet; arranging the cover plate on a side of the packaging layer away from the photovoltaic cell; and laminating the cover plate, the packaging layer, the photovoltaic cell, and the back sheet to form the photovoltaic module. According to the method for manufacturing a photovoltaic module provided in the present disclosure, process complexity of the photovoltaic module can be reduced, so that process steps are easier to implement.

## Description

### CROSS-REFERENCE TO RELATED APPLICATION(S)

The present disclosure claims the priority of Chinese Patent Application No. 202211075516.3, filed with the China National Intellectual Property Administration on September 5, 2022, and entitled "METHOD FOR MANUFACTURING PHOTOVOLTAIC MODULE, AND PHOTOVOLTAIC MODULE", the content of which is incorporated herein by reference in its entirety.

### TECHNICAL FIELD

The present disclosure relates to the field of photovoltaic technologies, and in particular, to a method for manufacturing a photovoltaic module and a photovoltaic module.

### BACKGROUND

A photovoltaic module generally includes a front packaging structure, a back packaging structure, photovoltaic cells, an insulating layer, and a conductive layer. Positive and negative electrode lines on the photovoltaic cell are required to be respectively connected to the conductive layer to form an electrical connection path. The insulating layer is configured to insulate and isolate regions on the photovoltaic cell from the conductive layer, except positions of the positive and negative electrode lines.

In the related art, the photovoltaic module has high requirements for precision during the manufacturing process, and thus process steps are relatively complicated.

### SUMMARY

The present disclosure provides a method for manufacturing a photovoltaic module and a photovoltaic module, which can reduce process complexity of manufacturing of the photovoltaic module.

In a first aspect of the present disclosure, a method for manufacturing a photovoltaic module is provided, including the following steps: providing a front packaging structure, a photovoltaic cell, and a back sheet, the front packaging structure includes a cover plate and a packaging layer; forming an insulating layer and forming through holes on a surface of at least one side of the photovoltaic cell, so that positions of the through holes correspond to electrode lines of the photovoltaic cell; forming a conductive layer on the back sheet; applying a conductive adhesive in the through holes and/or on the conductive layer; connecting the back sheet to the photovoltaic cell so that the insulating layer fits with the conductive layer and the conductive adhesive electrically connects the electrode lines and the conductive layer through the through holes; forming the packaging layer on a side of the photovoltaic cell away from the back sheet; arranging the cover plate on a side of the packaging layer away from the photovoltaic cell; and laminating the cover plate, the packaging layer, the photovoltaic cell, and the back sheet to form the photovoltaic module.

In one or more embodiments, during the forming an insulating layer and through holes on a surface of at least one side of the photovoltaic cell, the method includes: applying an insulating adhesive on the surface of the at least one side of the photovoltaic cell; and curing the insulating adhesive to form the insulating layer, and forming the through holes in regions where the insulating adhesive is not applied on the surface of the photovoltaic cell.

In one or more embodiments, the insulating adhesive is a transparent insulating adhesive.

In one or more embodiments, prior to the applying an insulating adhesive on the surface of the at least one side of the photovoltaic cell or subsequent to the curing the insulating adhesive to form the insulating layer, and forming the through holes in regions where the insulating adhesive is not applied on the surface of the photovoltaic cell, the method further includes: performing an electric performance test on the photovoltaic cell; and/or subsequent to the curing the insulating adhesive to form the insulating layer, and forming the through holes in regions where the insulating adhesive is not printed on the surface of the photovoltaic cell, the method further includes: performing sorting according to color and appearance of the photovoltaic cell.

In one or more embodiments, a thickness of the insulating layer is D1, and a thickness of the conductive adhesive is D2, where 1.2≤D2:D1≤1.5.

In one or more embodiments, during the forming a conductive layer on the back sheet, the method includes: arranging a mask on the back sheet; depositing a transparent metal oxide on a surface of the back sheet through an opening of the mask to form a metal conductive layer; and removing the mask, and forming an insulating groove in a region of the back sheet where the transparent metal oxide is not deposited.

In one or more embodiments, subsequent to the removing the mask, and forming an insulating groove in a region of the back sheet where the transparent metal oxide is not deposited, the method further includes: forming an electrode connection layer on a surface of the metal conductive layer by printing and sintering, the metal conductive layer and the electrode connection layer jointly constituting the conductive layer.

In one or more embodiments, the back sheet is made of one of glass, polycarbonate (PC), and polyethylene terephthalate (PET)

In one or more embodiments, the back sheet is made of one of polyvinyl fluoride (PVF), ethylene-tetra-fluoro-ethylene (ETFE), and polyvinylidene fluoride (PVDF), and prior to the laminating the cover plate, the packaging layer, the photovoltaic cell, and the back sheet to form the photovoltaic module, the method further includes: turning over the cover plate, the packaging layer, the photovoltaic cell, and the back sheet as a whole, so that the cover plate is below and the back sheet is above.

In a second aspect of the present disclosure, a photovoltaic module is provided, the photovoltaic module is manufactured by the manufacturing method as described above, and along a thickness direction of the photovoltaic module, the photovoltaic module includes: a back sheet, a conductive layer is arranged on the back sheet; a photovoltaic cell including an electrode, an insulating layer and through holes are formed on a surface of at least one side of the photovoltaic cell, so that positions of the through holes correspond to the electrode lines; a conductive adhesive located in the through hole, two ends of the conductive adhesive are connected to the conductive layer and the electrode line, respectively; a packaging layer covering a side of the photovoltaic cell away from the back sheet; and a cover plate covering a side of the packaging layer away from the photovoltaic cell, the cover plate and the back sheet jointly sandwiching the packaging layer and the photovoltaic cell.

In one or more embodiments, the conductive layer includes a metal conductive layer and an electrode connection layer, the electrode connection layer is formed on a surface on a side of the metal conductive layer close to the photovoltaic cell; and the conductive adhesive has one end connected to a positive electrode or a negative electrode of the photovoltaic cell and the other end connected to the electrode connection layer.

In one or more embodiments, the electrode connection layer is made of one or more of Au, Ag, Cu, Al, Bi, Sn, and Pb.

In one or more embodiments, an insulating groove is formed on the back sheet, and the conductive layer is arranged surrounding the insulating groove; and a region where the electrode connection layer is connected to the positive electrode of the photovoltaic cell and a region where the electrode connection layer is connected to the negative electrode of the photovoltaic cell are located on two sides of the insulating groove.

According to the method for manufacturing a photovoltaic module provided in the present disclosure, the insulating layer is directly arranged on a surface of the photovoltaic cell, which can reduce process complexity of the manufacturing of the photovoltaic module, and can further improve accuracy of positions of the through holes to ensure that the through holes are provided at positions corresponding to the electrode lines, thereby reducing the risk of insufficient contact of the conductive adhesive due to misalignment of the through hole and the electrode line. In the lamination process, risks of insufficient contact and short circuit caused by position changes of the conductive adhesive caused by misalignment of the insulating layer and the photovoltaic cell during the lamination can also be reduced. In addition, the conductive layer is further directly arranged on the surface of the back sheet, which can also reduce the risk of insufficient contact due to misalignment of the conductive adhesive.

It should be understood that the general description above and the detailed description in the following are merely exemplary and illustrative, and cannot limit the present disclosure.

### BRIEF DESCRIPTION OF DRAWINGS

FIG. 1 is a schematic structural diagram of a photovoltaic module according to one or more embodiments of the present disclosure;
FIG. 2 is a flowchart of manufacturing of the photovoltaic module according to one or more embodiments of the present disclosure;
FIG. 3 is a schematic structural diagram of a surface on one side of a photovoltaic cell;
FIG. 4 is a flowchart of manufacturing of the photovoltaic module according to one or more embodiments of the present disclosure;
FIG. 5 is a flowchart of manufacturing of the photovoltaic module according to one or more embodiments of the present disclosure;
FIG. 6 is a flowchart of manufacturing of the photovoltaic module according to one or more embodiments of the present disclosure;
FIG. 7 is a schematic diagram of a sectional structure of a photovoltaic module;
FIG. 8 is a schematic diagram of a sectional structure of a photovoltaic cell;
FIG. 9 is a flowchart of manufacturing of the photovoltaic module according to one or more embodiments of the present disclosure;
FIG. 10 is a flowchart of manufacturing of the photovoltaic module according to one or more embodiments of the present disclosure;
FIG. 11 is a schematic structural diagram of a back sheet; and
FIG. 12 is a flowchart of manufacturing of the photovoltaic module according to one or more embodiments of the present disclosure.

### Reference signs:

1: back sheet;
   11: conductive layer;
   111: metal conductive layer;
   112: electrode connection layer;
   113: insulating groove;
2: photovoltaic cell;
   20: electrode line;
   21: insulating layer;
      211: through hole;
3: conductive adhesive;
4: packaging layer;
5: cover plate.

The accompanying drawings herein, which are incorporated in and constitute a part of this specification, illustrate embodiments consistent with the present disclosure and, together with the specification, serve to explain principles of the present disclosure.

### DESCRIPTION OF EMBODIMENTS

In order to better understand the technical solutions of the present disclosure, embodiments of the present disclosure will be described in detail below in conjunction with the accompanying drawings.

It should be clear that the described embodiments are only some rather than all of the embodiments of the present disclosure. Based on the embodiments in the present disclosure, all other embodiments obtained by those of ordinary skill in the art without creative efforts fall within the protection scope of the present disclosure.

Terms used in the embodiments of the present disclosure are only for the purpose of describing specific embodiments, and are not intended to limit the present disclosure. Singular forms of "a/an", "the", and "said" used in the embodiments of the present disclosure and the appended claims are intended to include plural forms, unless otherwise clearly specified in the context.

It should be understood that the term "and/or" used herein describes an association relationship between associated objects and represents that three relationships may exist. For example, A and/or B may represent the following three cases: only A exists, both A and B exist, and only B exists. In addition, the character "/" herein generally indicates an "or" relationship between the associated objects.

It is to be noted that orientation terms such as "above", "below", "left", and "right" described in the embodiments of the present disclosure are described from the perspective shown in the accompanying drawings, and should not be construed as limiting the embodiments of the present disclosure. Besides, in this context, it is to be further understood that one element described as being connected "above" or "below" another element not only means that the element may be directly connected "above" or "below" the other element, but also means that the element may be indirectly connected "above" or "below" the other element through an intermediate element.

In existing methods for manufacturing photovoltaic module, generally, an insulating layer and a conductive layer are arranged separately, and then a photovoltaic cell, the insulating layer, the conductive layer, and a back sheet are laminated and assembled, which is complicated in process and easily leads to insufficient contact between the photovoltaic cell and the back sheet.

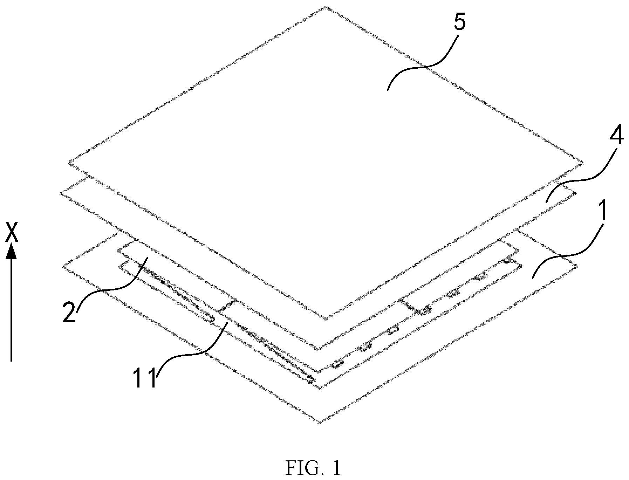

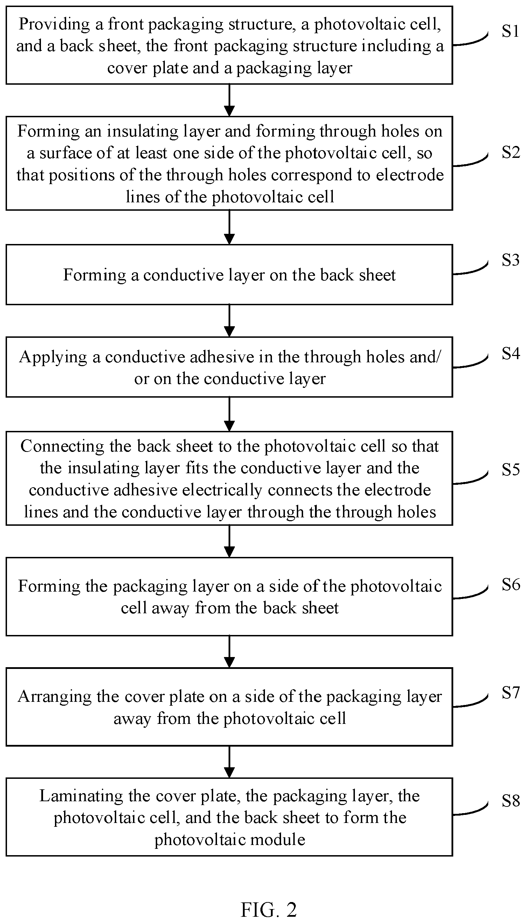

In view of the above, some embodiments of the present disclosure provide a method for manufacturing a photovoltaic module. As shown in FIG. 1 and FIG. 2, the method includes the following steps.

In S1, a front packaging structure, a photovoltaic cell 2, and a back sheet 1 are provided, and the front packaging structure includes a cover plate 5 and a packaging layer 4.

As shown in FIG. 1, for the photovoltaic module, the cover plate 5, the packaging layer 4, the photovoltaic cell 2, and the back sheet 1 are laminated and packaged to constitute a photovoltaic module that can be used in outdoor environments for a long time. The packaging process can ensure that the photovoltaic cell 2 has good mechanical strength and reduce influences of for example hail impact, wind blowing, mechanical vibration, and the like. The packaging process can also improve sealing performance of the photovoltaic cell 2 and improve corrosion resistance and safety thereof.

In S2, an insulating layer 21 and a through hole 211 are provided on a surface on at least one side of the photovoltaic cell 2, so that the position of the through hole 211 corresponds to an electrode line 20 of the photovoltaic cell 2.

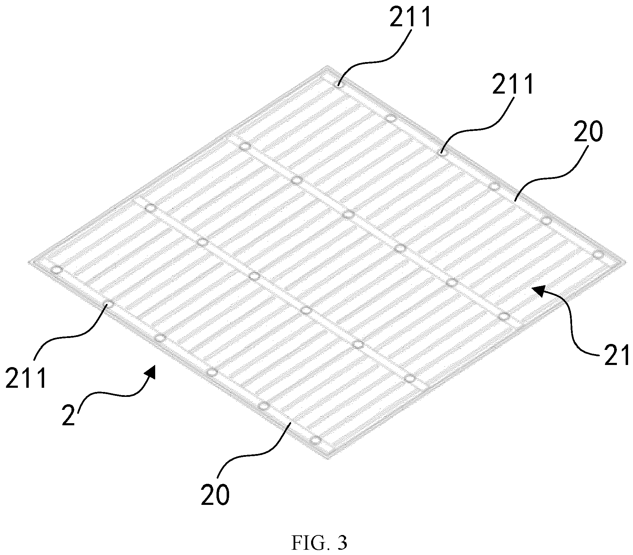

As shown in FIG. 3, the insulating layer 21 covers a surface of the photovoltaic cell 2, which can prevent short circuit caused by communication between positive and negative electrode lines of the photovoltaic cell 2. A plurality of through holes 211 are formed at positions of the insulating layer 21 corresponding to the electrode lines 20 of the photovoltaic cell 2. The through hole 211 is configured to implement an electrical connection between the photovoltaic cell 2 and the back sheet 1. Compared with the related art in which the insulating layer is arranged separately and then is connected to the photovoltaic cell 2, the insulating layer 21 according to embodiments of the present disclosure is directly arranged on the surface of the photovoltaic cell 2, which can reduce process complexity of the photovoltaic module, save a layout process of the insulating layer 21, and make process steps easier to implement, and can also reduce the manufacturing cost of the photovoltaic module. In the subsequent lamination process, risks of insufficient contact and a short circuit caused by a change in a position of the conductive adhesive 3 caused by misalignment of the insulating layer 21 and the photovoltaic cell 2 during the lamination can also be reduced.

In addition, the direct arrangement of the insulating layer 21 on the surface of the photovoltaic cell 2 can also improve adhesion between the insulating layer 21 and the photovoltaic cell 2, which is conducive to improving the insulating effect of the insulating layer 21, thereby improving electrical insulation of the photovoltaic module and then prolonging the service life and improving safety of the photovoltaic module.

For example, the insulating layer 21 and the through hole 211 may be simultaneously manufactured by screen printing or mask printing. Alternatively, the surface of the photovoltaic cell 2 is first entirely coated with the insulating layer 21, and then part of the insulating layer 21 at the positions corresponding to the electrode lines 20 are removed to form the through holes 211.

The photovoltaic cell 2 in the present disclosure may be a single cell or includes a plurality of cells connected in series/parallel.

In S3, a conductive layer 11 is formed on the back sheet 1.

Compared with the related art in which the conductive layer 11 is arranged separately and then is connected to the back sheet and the photovoltaic cell, the conductive layer 11 according to embodiments of the present disclosure is directly arranged on a surface of the back sheet 1, which can further reduce process complexity of the photovoltaic module.

In S4, a conductive adhesive 3 is provided in the through hole 211 and/or on the conductive layer 11.

The conductive adhesive 3 is provided in the through hole 211 and/or on the conductive layer 11, and the conductive adhesive 3 is configured to implement an electrical connection between the positive and negative electrode lines of the photovoltaic cell 2 and the conductive layer 11.

In S5: The back sheet 1 is connected to the photovoltaic cell 2, so that the insulating layer 21 fits the conductive layer 11 and then the conductive adhesive 3 electrically connects the electrode line 20 and the conductive layer 11 through the through hole 211.

When the photovoltaic cell 2 is connected to the back sheet 1, the conductive adhesive 3 electrically connects the electrode line 20 and the conductive layer 11 through the through hole 211, which can improve stability of electrical connection of the photovoltaic module, thereby increasing the yield of the photovoltaic module.

In S6, the packaging layer 4 is formed on a side of the photovoltaic cell 2 away from the back sheet 1.

The packaging layer 4 is configured to protect a side of the photovoltaic cell 2 away from the back sheet 1, and at the same time, can bond the cover sheet 5, the photovoltaic cell 2, and the back sheet 1 into an entirety. The packaging layer 4 may be made of one of an Ethylene-Vinyl Acetate Copolymer (EVA), a Polyolefin Elastomer (POE), and Polyvinyl Butyral (PVB), and has a thickness greater than 300 µm, so as to meet the packaging requirement of the photovoltaic module. In some embodiments, the thickness of the packaging layer 4 ranges from 400 µm to 800 µm, which can ensure good mechanical strength of the photovoltaic module and help improve the yield and reliability of the photovoltaic module.

In S7, the cover plate 5 is arranged on a side of the packaging layer 4 away from the photovoltaic cell 2.

The cover plate 5 is located on an uppermost layer of the photovoltaic module, is configured to transmit sunlight and also configured to improve waterproof and moisture-proof capabilities of the photovoltaic module, and seals the photovoltaic cell 2 together with the back sheet 1. The cover plate 5 may be made of one of rigid materials such as tempered glass, PET, and PC, or one of flexible materials such as PVF, ETFE, and PVDF. The above materials have higher light transmittance, which can ensure that more light is irradiated on the surface of the photovoltaic cell 2, thereby increasing light absorption of the photovoltaic module.

In S8, the cover plate 5, the packaging layer 4, the photovoltaic cell 2, and the back sheet 1 are laminated to form the photovoltaic module.

Lamination is to bond and fuse various components of the photovoltaic module together under certain temperature, pressure, and vacuum conditions, so as to protect the photovoltaic cell 2.

According to the method for manufacturing a photovoltaic module provided in the present disclosure, the insulating layer 21 is directly arranged on the surface of the photovoltaic cell 2, which can reduce process complexity of the manufacturing of the photovoltaic module, and can further improve accuracy of the positions of the through holes 211 to ensure that the through holes are provided at positions corresponding to the electrode lines 20, thereby reducing the risk of insufficient contact of the conductive adhesive 3 due to misalignment of the through holes 211 and the electrode lines 20. In the lamination process, risks of insufficient contact and short circuit caused by position changes of the conductive adhesive 3 caused by misalignment of the insulating layer 21 and the photovoltaic cell 2 during the lamination can also be reduced. At the same time, the conductive layer 11 is further directly arranged on the surface of the back sheet 1, which can also reduce the risk of insufficient contact due to misalignment of the conductive adhesive 3.

It is to be noted that the photovoltaic cell 2 has two side surfaces arranged opposite to each other, for example, a light-facing surface and a backlight surface. The light-facing surface refers to a side surface of the photovoltaic cell 2 facing a light source and used to directly receive sunlight. The backlight surface refers to a side surface of the photovoltaic cell 2 facing away from the light source and used to receive sunlight reflected by the ground.

For example, in some embodiments, "an insulating layer 21 and a through hole 211 are arranged on a surface on at least one side of the photovoltaic cell 2" means that the insulating layer 21 and the through hole 211 are arranged on the backlight surface or the insulating layer 21 and the through hole 211 are arranged on both the light-facing surface and the backlight surface. The photovoltaic cell 2 may be a back contact cell. Compared with the conventional solar cell, the positive and negative electrode lines according to the present disclosure are arranged on the backlight surface of the photovoltaic cell 2, and no metal electrode line is arranged on the light-facing surface, which can reduce shielding of the sunlight and increase a light-receiving area of the photovoltaic cell 2, thereby improving photoelectric conversion efficiency of the photovoltaic module. Moreover, when the photovoltaic cell 2 is the back contact cell, the insulating layer 21 and the through hole 211 are required to be arranged only on the backlight surface, which can further reduce the manufacturing cost of the photovoltaic module.

In addition, the shape of the electrode line 20 is not limited in the present disclosure, which may be a through-type or segmented electrode line or spot electrode points.

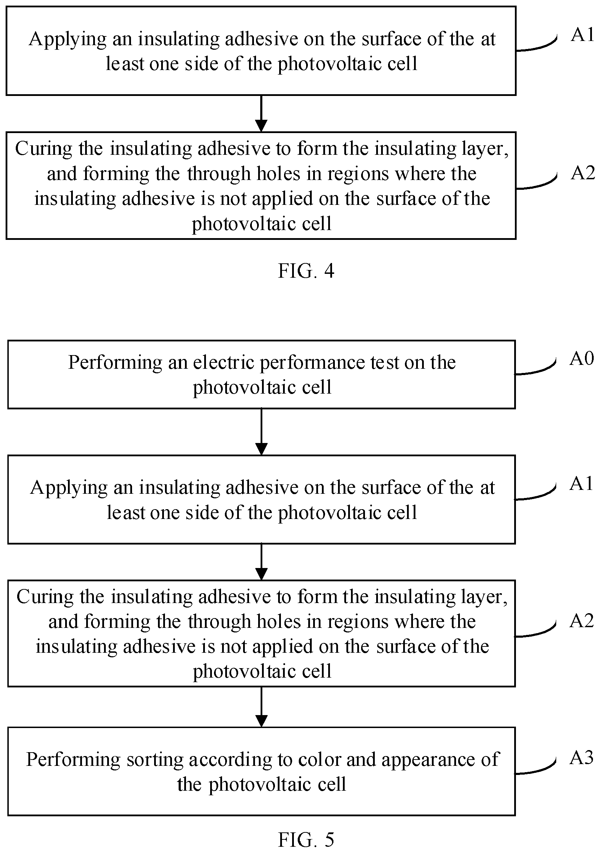

In some embodiments, as shown in FIG. 4, for S2 of arranging an insulating layer 21 and a through hole 211 on a surface on at least one side of the photovoltaic cell 2, the method for manufacturing a photovoltaic module includes the following steps.

In A1, an insulating adhesive is printed on the surface on the at least one side of the photovoltaic cell 2.

"Printing an insulating adhesive" may be attaching, by screen printing, a template with a pattern to a screen for printing. The photovoltaic cell 2 is placed under the screen with the template, and the insulating adhesive passes through meshes in the middle of the screen under extrusion of a scraper and is printed on the surface of the photovoltaic cell 2. The template on the screen seals part of small holes of the screen, and the insulating adhesive cannot pass therethrough. Therefore, on the surface of the photovoltaic cell 2, only positions corresponding to an image of the screen are coated with the insulating adhesive, while the through holes 211 are formed at the remaining positions. For example, at the positions corresponding to the electrode lines 20 on the template of the screen, part of the screen holes are sealed to ensure that the positions of the through holes 211 are accurate. The thickness of the screen ranges from 10 µm to 200 µm, and the thickness of the insulating adhesive after printing ranges from 15 µm to 300 µm, so as to ensure that the insulating layer 21 finally formed can have good insulating effect.

In addition, "printing an insulating adhesive" may alternatively be using, by mask printing, a mask printed with a pattern for printing. The principle and the effect are the same as those of screen printing. Details are not described herein again.

In A2, the insulating adhesive is cured to form the insulating layer 21, and the through hole 211 is formed in a region where the insulating adhesive is not printed on the surface of the photovoltaic cell 2.

After printed with the insulating adhesive, the photovoltaic cell 2 may be subjected to a curing process to form the insulating layer 21. Generally, a high-temperature curing process is adopted, and the curing temperature ranges from 100°C to 200°C, which prevents failure of the insulating adhesive due to an excessively high temperature. At the same time, curing time should be controlled within 10 min to improve manufacturing efficiency of the photovoltaic module.

For example, the insulating adhesive in some embodiments covers an entire surface of the photovoltaic cell 2 except for the through holes 211. During the lamination process, in addition to the insulating effect, the insulating adhesive can also cushion the photovoltaic cell 2 and the back sheet 1, thereby reducing the fragment rate of the lamination and increasing the yield of the photovoltaic module.

In addition, when cured, the insulating adhesive may not be completely cured, so as to maintain certain viscosity. When the photovoltaic cell 2 is connected to the back sheet 1, the insulating adhesive can connect the photovoltaic cell 2 and the back sheet 1 to achieve a temporary fixation effect. In a subsequent process, there is no need to temporarily fix the photovoltaic cell 2 and the back sheet 1, which further simplifies the process steps for manufacturing the photovoltaic module. Complete curing of the insulating adhesive is realized in the lamination process.

In some embodiments, the insulating adhesive is a transparent insulating adhesive.

The insulating adhesive may be one or more of silicone, acrylic acid, and epoxy resin, a viscosity thereof prior to the curing ranges from 0 to 50 Pa•s, and light transmittance after the curing may be more than 75%, so that higher light transmittance is maintained on the backlight surface of the photovoltaic cell 2, thereby receiving more light reflected from the ground into the photovoltaic module and facilitating to implement double-sided power generation of the photovoltaic module.

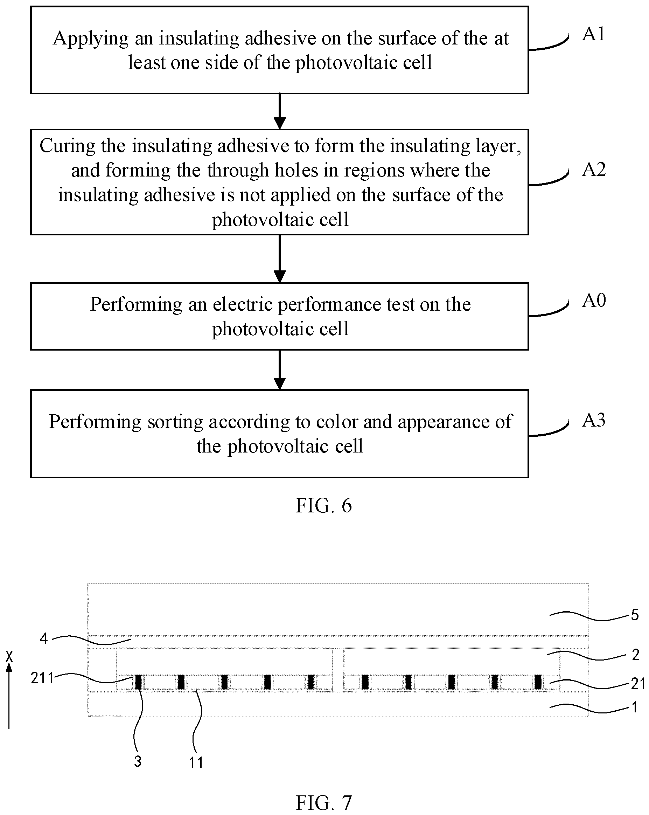

In some embodiments, as shown in FIG. 5 and FIG. 6, prior to A1 or subsequent to A2, the method for manufacturing a photovoltaic module further includes the following step.

In A0, an electric performance test is performed on the photovoltaic cell 2.

Due to randomness of cell manufacturing conditions, performance of the manufactured photovoltaic cells 2 varies. In order to effectively combine the photovoltaic cells 2 with the same or similar performance, the photovoltaic cells should be classified according to performance parameters. Through the detection of the photovoltaic cell 2, utilization can be improved, and a qualified photovoltaic module can be manufactured. The electric performance test is mainly to test basic characteristics of the photovoltaic cell 2 to detect an outdoor power generation capability of the photovoltaic cell 2.

The electric performance test may be prior to or subsequent to the process of arranging the insulating layer 21 and the through hole 211. During the test, the position of a test tool should be consistent with the position of the through hole 211 to ensure accuracy of test results.

Additionally/alternatively, subsequent to A2, the method for manufacturing a photovoltaic module further includes the following step.

In A3, sorting is performed according to the color and the appearance of the photovoltaic cell 2.

After the process of arranging the insulating layer 21 and the through hole 211, the color and the appearance of the photovoltaic cell 2 are required to be sorted. The thickness, defects, and flatness of the photovoltaic cell 2 are inspected mainly by visual inspection. In addition, the color of the photovoltaic cell 2 should remain uniform without any obvious color difference.

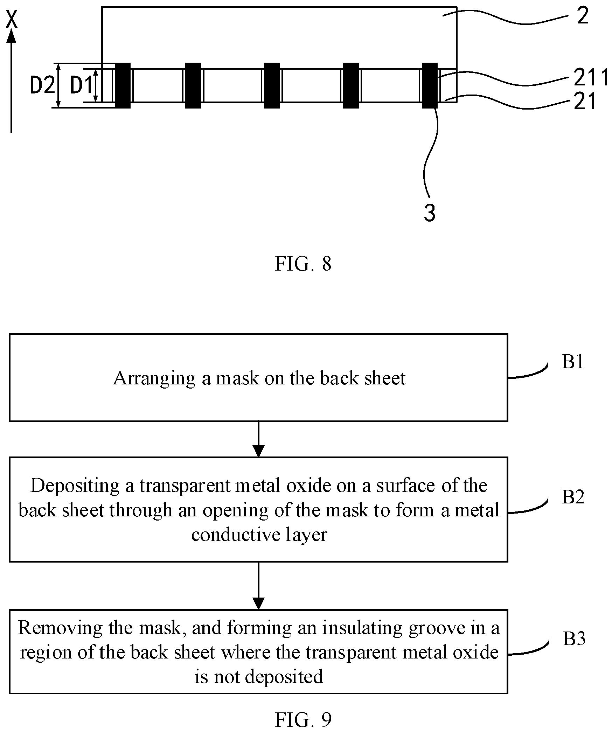

In some embodiments, as shown in FIG. 7 and FIG. 8, a thickness of the insulating layer 21 is D1, and a thickness of the conductive adhesive 3 is D2, where 1.2≤D2:D1≤1.5. For example, D2:D1 may be 1.2, 1.3, 1.4, 1.5, or the like.

In some embodiments, the thickness D2 of the conductive adhesive 3 is greater than the thickness D1 of the insulating layer 21, which should not be excessively large or excessively small. For example, the thickness D2 of the conductive adhesive 3 and the thickness D1 of the insulating layer 21 should satisfy 1.2≤D2:D1≤1.5. When D2:D1 is excessively large (e.g., greater than 1.5), the amount of the conductive adhesive 3 increases, resulting in increase of the manufacturing cost of the photovoltaic module, but the conductive effect of the conductive adhesive 3 is not significantly improved. When D2:D1 is excessively small (e.g., less than 1.2), the thickness D2 of the conductive adhesive 3 is close to the thickness D1 of the insulating layer 21, and the amount of the conductive adhesive 3 is insufficient to fill the through hole 211, which cannot ensure stable electrical connection of the conductive adhesive 3 with the electrode line 20 and the conductive layer 11.

As shown in the following table, when the values of D2 and D1 are different, a basic situation of a finished photovoltaic module is shown in the following table:

| D2:D1 | Cost of the photovoltaic module (the cost is 100% when D2:D1=1.3) | Insufficient contact rate between electrode line and conductive layer | Defective rate of photovoltaic module |
|---|---|---|---|
| 0.9 | 98.5% | 1.8% | 2.0% |
| 1 | 99% | 1.2% | 1.3% |
| 1.3 | 100% | 0.5% | 0.9% |
| 1.5 | 101% | 0.5% | 0.8% |
| 1.8 | 105% | 0.5% | 0.8% |
| 2.0 | 108% | 0.48% | 0.8% |

In addition, the conductive adhesive 3 can be directly applied in the through hole 211 by dispensing, or the conductive adhesive 3 is printed at positions corresponding to the conductive layer 11 and the through hole 211 by printing.

In some embodiments, as shown in FIG. 9, for S3 of arranging a conductive layer 11 on the back sheet 1, the method for manufacturing a photovoltaic module includes the following steps.

In B2, a mask is arranged on the back sheet 1.

A mask with a pattern closely fits the surface of the back sheet 1 to indicate a region where the conductive layer 11 is required to be arranged.

The back sheet 1 is made of a material with high light transmittance, which can further improve the double-sided power generation capability of the photovoltaic module.

In B2, a transparent metal oxide is deposited on a surface of the back sheet 1 through an opening of the mask to form a metal conductive layer 111.

The transparent metal oxide is deposited on the surface of the back sheet 1 physically and/or chemically to form the metal conductive layer 111, with a thickness ranging from 10 µm to 100 µm. The transparent metal oxide may be one or more of In₂O₃, SnO₂, ZnO, CdO, CdIn₂O₄, Cd₂SnO₄, Zn₂SnO₄, and In₂O₃-ZnO. The transparent metal conductive layer 111 can ensure that more light reflected by the ground irradiates the backlight surface of the photovoltaic cell 2, which is conducive to implementing double-sided power generation of the photovoltaic module.

In B3, the mask is removed, and an insulating groove 113 is formed in a region of the back sheet 1 where the transparent metal oxide is not deposited.

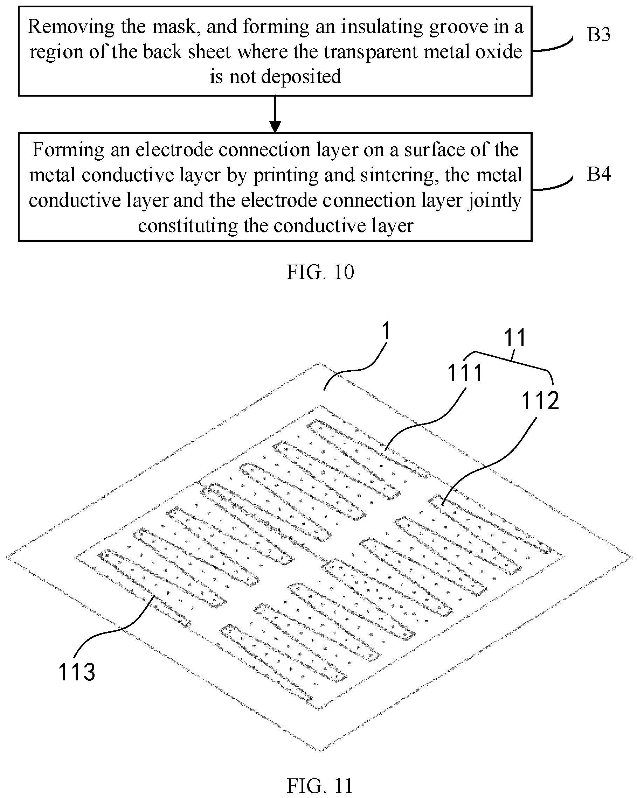

As shown in FIG. 11, no transparent metal oxide is deposited in a region covered by the mask on the surface of the back sheet 1, and thus the insulating groove 113 is formed, which can insulate and isolate the region where the metal conductive layer 111 is connected to the positive electrode of the photovoltaic cell 2 and the region where the metal conductive layer 111 is connected to the negative electrode of the photovoltaic cell 2 to prevent short circuit.

In some embodiments, as shown in FIG. 10, subsequent to B3, the method for manufacturing a photovoltaic module further includes the following step.

In B4, an electrode connection layer 112 is formed on a surface of the metal conductive layer 111 by printing and sintering, and the metal conductive layer 111 and the electrode connection layer 112 jointly constitute the conductive layer 11.

The arrangement of the electrode connection layer 112 can improve stability of the electrical connection between the metal conductive layer 111 and the electrode line 20 and reduce the risk of insufficient contact of the photovoltaic module. For example, the electrode connection layer 112 is formed by printing and sintering slurry containing high-conductive materials, so that the electrode connection layer 112 can be firmly attached to the metal conductive layer 111.

The specific structure of the electrode connection layer 112 is not limited in this embodiment, which may be linear, spot-shaped, or have other structures.

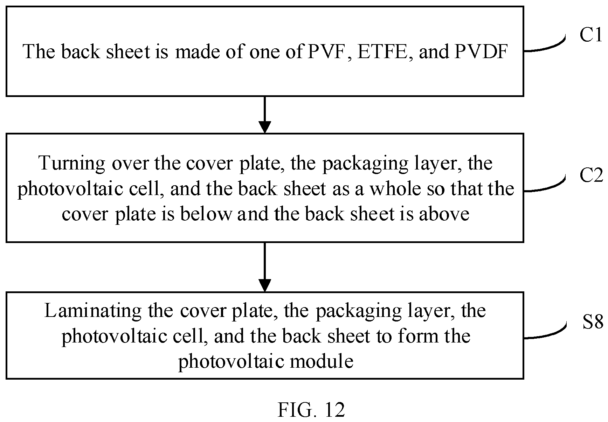

In some embodiments, as shown in FIG. 12, the back sheet 1 is made of one of PVF, ETFE, and PVDF, and prior to S7, the method for manufacturing a photovoltaic module further includes the following step.

In C2, the cover plate 5, the packaging layer 4, the photovoltaic cell 2, and the back sheet 1 are turned over as a whole so that the cover plate 5 is below and the back sheet 1 is above.

The back sheet 1 is made of a flexible material. In order to prevent deformation and cracking during the lamination caused by contact between the flexible material and a charging table, prior to the lamination process, there is a need to turn over the cover plate 5, the packaging layer 4, the photovoltaic cell 2, and the back sheet 1 as a whole so that the cover plate 5 is below and the back sheet 1 is above, and then the photovoltaic module turned over is placed on the charging table of a laminator, thereby preventing damages to the back sheet 1 during the lamination and increasing the yield of the photovoltaic module.

In addition, PVF, ETFE, and PVDF are all transparent materials with high light transmittance, with thicknesses ranging from 0.2 mm to 6 mm, which can ensure that more light reflected by the ground is irradiated to the backlight surface of the photovoltaic cell 2, facilitating to implement double-sided power generation of the photovoltaic module.

In some embodiments, the back sheet 1 is made of one of glass, PC, and PET.

For example, the back sheet 1 is made of a rigid material. In the lamination process, there is no need to turn over the photovoltaic module as a whole but directly place the photovoltaic module on the charging table of the laminator. In this case, the back sheet 1 is in contact with the charging table, and may not be deformed and broken during the lamination due to high rigidity thereof. Compared with the back sheet 1 made of the flexible material, the rigid back sheet 1 can reduce complexity of the process, save the turning-over step prior to the lamination, and reduce the risk of defective photovoltaic module during the manufacturing.

In addition, glass, PC, and PET are all transparent materials with high light transmittance, with thicknesses ranging from 0.2 mm to 6 mm, which can ensure that more light reflected by the ground is irradiated to the backlight surface of the photovoltaic cell 2, facilitating to implement double-sided power generation of the photovoltaic module.

Some embodiments of the present disclosure further provide a photovoltaic module. The photovoltaic module is manufactured with the method in the above embodiments. As shown in FIG. 1, FIG. 3, and FIG. 7, along a thickness direction X of the photovoltaic module, the photovoltaic module includes: a back sheet 1, a photovoltaic cell 2, a conductive adhesive 3, a packaging layer 4, and a cover plate 5. A conductive layer 11 is arranged on the back sheet 1. The photovoltaic cell 2 includes an electrode line 20, an insulating layer 21 and a through hole 211 are arranged on a surface on at least one side of the photovoltaic cell 2, and a position of the through hole 211 corresponds to the electrode line 20. The conductive adhesive 3 is located in the through hole 211, and two ends of the conductive adhesive 3 are connected to the conductive layer 11 and the electrode line 20, respectively. The packaging layer 4 covers a side of the photovoltaic cell 2 away from the back sheet 1. The cover plate 5 covers a side of the packaging layer 4 away from the photovoltaic cell 2, and the cover plate 5 and the back sheet 1 jointly sandwich the packaging layer 4 and the photovoltaic cell 2.

In some embodiments, the insulating layer 21 covers the surface of the photovoltaic cell 2, which can insulate the electrode line 20 from the conductive layer 11 and prevent short circuit caused by communication between positive and negative electrode lines of the photovoltaic cell 2. A plurality of through holes 211 are formed at a position of the insulating layer 21 corresponding to the electrode lines 20 of the photovoltaic cell 2. When the photovoltaic cell 2 is connected to the back sheet 1, the conductive adhesive 3 is arranged in the through hole 211 and/or on the conductive layer 11, so that the conductive adhesive electrically connects the electrode line 20 and the conductive layer 11 through the through hole 211, which can improve stability of electrical connection of the photovoltaic module, thereby increasing the yield of the photovoltaic module.

In some embodiments, the insulating layer 21 is directly formed on the surface of the photovoltaic cell 2 and the conductive layer 11 is directly formed on the surface of the back sheet 1, which can reduce process complexity of the photovoltaic module and save a layout process of the insulating layer 21 and the conductive layer 11, making process steps easier to implement. At the same time, the risk of insufficient contact of the conductive adhesive 3 due to misalignment of the through hole 211 and the electrode line 20. In the lamination process, risks of insufficient contact and short circuit caused by position changes of the conductive adhesive 3 caused by misalignment of the insulating layer 21 and the photovoltaic cell 2 during the lamination can also be reduced.

For example, as shown in FIG. 11, the conductive layer 11 includes a metal conductive layer 111 and an electrode connection layer 112, the electrode connection layer 112 is arranged on a surface on a side of the metal conductive layer 111 close to the photovoltaic cell 2, and the conductive adhesive 3 has one end connected to a positive electrode or a negative electrode of the photovoltaic cell 2 and the other end connected to the electrode connection layer 112.

As shown in FIG. 2, a plurality of electrode lines 20 are arranged at intervals on the surface of the photovoltaic cell 2. The electrode lines 20 include positive electrode lines and negative electrode lines. The through hole 211 exposes part of a region of the positive electrode line, and the conductive adhesive 3 communicates the region with the conductive layer 11 in the through hole 211, so as to achieve the purpose of electrically connecting the positive electrode of the photovoltaic cell 2 and the conductive layer 11. Similarly, the through hole 211 exposes part of a region of the negative electrode line, and the conductive adhesive 3 communicates the region with the conductive layer 11 in the through hole 211, so as to achieve the purpose of electrically connecting the negative electrode of the photovoltaic cell 2 and the conductive layer 11.

The conductive layer 11 includes a metal conductive layer 111 and an electrode connection layer 112, and the electrode connection layer 112 is firmly attached to the metal conductive layer 111, for improving stability of the electrical connection between the metal conductive layer 111 and the electrode line 20 and reducing the risk of insufficient contact of the photovoltaic module.

In some embodiments, the electrode connection layer 112 is made of one or more of Au, Ag, Cu, Al, Bi, Sn, and Pb.

Au, Ag, Cu, Al, Bi, Sn, and Pb all have strong electrical conductivity. One or more of the above materials are selected and made into highly conductive slurry, and then the slurry is printed on the metal conductive layer 111 and is sintered to form the electrode connection layer 112, which can ensure that the conductive layer 11 has good conductive effect, thereby preventing insufficient contact of the photovoltaic module.

In some embodiments, as shown in FIG. 11, an insulating groove 113 is formed on the back sheet 1, and the conductive layer 11 is arranged around the insulating groove 113. A region where the electrode connection layer 112 is connected to the positive electrode of the photovoltaic cell 2 and a region where the electrode connection layer 112 is connected to the negative electrode of the photovoltaic cell 2 are located on two sides of the insulating groove 113.

The insulating groove 113 is formed on the conductive layer 11, which can insulate and isolate a region where the metal conductive layer 111 is connected to the positive electrode of the photovoltaic cell 2 from a region where the metal conductive layer 111 is connected to the negative electrode of the photovoltaic cell 2, thereby preventing short circuit caused by connection between the positive and negative electrodes of the photovoltaic cell 2 and improving reliability and safety of the photovoltaic module.

The above descriptions are only preferred embodiments of the present disclosure, and are not intended to limit the present disclosure. For those skilled in the art, various modifications and changes may be made to the present disclosure. Any modifications, equivalent replacements, improvements, and the like made within the spirit and the principle of the present disclosure shall fall within the protection scope of the present disclosure.

## Claims

1. A method for manufacturing a photovoltaic module, comprising:
providing a front packaging structure, a photovoltaic cell (2), and a back sheet (1), the front packaging structure comprising a cover plate (5) and a packaging layer (4);
forming an insulating layer (21) and forming through holes (211) on a surface of at least one side of the photovoltaic cell (2), so that positions of the through holes (211) correspond to electrode lines (20) of the photovoltaic cell (2);
forming a conductive layer (11) on the back sheet (1);
applying a conductive adhesive (3) in the through holes (211) and/or on the conductive layer (11);
connecting the back sheet (1) to the photovoltaic cell (2) so that the insulating layer (21) fits with the conductive layer (11) and the conductive adhesive (3) electrically connects the electrode lines (20) and the conductive layer (11) through the through holes (211);
forming the packaging layer (4) on a side of the photovoltaic cell (2) away from the back sheet (1);
arranging the cover plate (5) on a side of the packaging layer (4) away from the photovoltaic cell (2); and
laminating the cover plate (5), the packaging layer (4), the photovoltaic cell (2), and the back sheet (1) to form the photovoltaic module.

2. The method for manufacturing a photovoltaic module according to claim 1, wherein, during the forming an insulating layer (21) and forming through holes (211) on a surface of at least one side of the photovoltaic cell (2), the method comprises:
applying an insulating adhesive on the surface of the at least one side of the photovoltaic cell (2); and
curing the insulating adhesive to form the insulating layer (21), and forming the through holes (211) in regions where the insulating adhesive is not applied on the surface of the photovoltaic cell (2).

3. The method for manufacturing a photovoltaic module according to claim 2, wherein the insulating adhesive is a transparent insulating adhesive.

4. The method for manufacturing a photovoltaic module according to claim 2, wherein prior to the applying an insulating adhesive on the surface of the at least one side of the photovoltaic cell (2) or subsequent to the curing the insulating adhesive to form the insulating layer (21), and forming the through holes (211) in the regions where the insulating adhesive is not applied on the surface of the photovoltaic cell (2), the method further comprises: performing an electric performance test on the photovoltaic cell (2); and/or
subsequent to the curing the insulating adhesive to form the insulating layer (21), and forming the through holes (211) in the regions where the insulating adhesive is not applied on the surface of the photovoltaic cell (2), the method further comprises: performing sorting according to color and appearance of the photovoltaic cell (2).

5. The method for manufacturing a photovoltaic module according to any one of claims 1 to 4, wherein a thickness of the insulating layer (21) is D1, and a thickness of the conductive adhesive (3) is D2, where 1.2≤D2:D1≤1.5.

6. The method for manufacturing a photovoltaic module according to any one of claims 1 to 4, wherein, during the forming a conductive layer (11) on the back sheet (1), the method comprises:
arranging a mask on the back sheet (1);
depositing a transparent metal oxide on a surface of the back sheet (1) through an opening of the mask to form a metal conductive layer (111); and
removing the mask, and forming an insulating groove (113) in a region of the back sheet (1) where the transparent metal oxide is not deposited.

7. The method for manufacturing a photovoltaic module according to claim 6, wherein subsequent to the removing the mask, and forming an insulating groove (113) in the region of the back sheet (1) where the transparent metal oxide is not deposited, the method further comprises:
forming an electrode connection layer (112) on a surface of the metal conductive layer (111) by printing and sintering, the metal conductive layer (111) and the electrode connection layer (112) jointly constituting the conductive layer (11).

8. The method for manufacturing a photovoltaic module according to claim 6, wherein the back sheet (1) is made of one of glass, polycarbonate (PC), and polyethylene terephthalate (PET).

9. The method for manufacturing a photovoltaic module according to claim 6, wherein the back sheet (1) is made of one of polyvinyl fluoride (PVF), ethylene-tetra-fluoro-ethylene (ETFE), and polyvinylidene fluoride (PVDF), and prior to the laminating the cover plate (5), the packaging layer (4), the photovoltaic cell (2), and the back sheet (1) to form the photovoltaic module, the method further comprises:
turning over the cover plate (5), the packaging layer (4), the photovoltaic cell (2), and the back sheet (1) as a whole, so that the cover plate (5) is below and the back sheet (1) is above.

10. A photovoltaic module, manufactured by the method according to any one of claims 1 to 9, and along a thickness direction of the photovoltaic module, the photovoltaic module comprises:
a back sheet (1), wherein a conductive layer (11) is formed on the back sheet (1);
a photovoltaic cell (2) comprising electrode lines (20), wherein an insulating layer (21) and through holes (211) are formed on a surface of at least one side of the photovoltaic cell (2), so that positions of the through holes (211) correspond to the electrode lines (20);
a conductive adhesive (3) located in the through holes (211), wherein two ends of the conductive adhesive (3) are connected to the conductive layer (11) and the electrode line (20), respectively;
a packaging layer (4) covering a side of the photovoltaic cell (2) away from the back sheet (1); and
a cover plate (5) covering a side of the packaging layer (4) away from the photovoltaic cell (2), wherein the cover plate (5) and the back sheet (1) jointly sandwiching the packaging layer (4) and the photovoltaic cell (2).

11. The photovoltaic module according to claim 10, wherein the conductive layer (11) comprises a metal conductive layer (111) and an electrode connection layer (112), the electrode connection layer (112) is formed on a surface on a side of the metal conductive layer (111) close to the photovoltaic cell (2); and
the conductive adhesive (3) has one end connected to a positive electrode or a negative electrode of the photovoltaic cell (2) and the other end connected to the electrode connection layer (112).

12. The photovoltaic module according to claim 11, wherein the electrode connection layer is made of one or more of Au, Ag, Cu, Al, Bi, Sn, and Pb.

13. The photovoltaic module according to claim 11, wherein an insulating groove (113) is formed on the back sheet (1), and the conductive layer (11) is arranged surrounding the insulating groove (113); and
a region where the electrode connection layer (112) is connected to the positive electrode of the photovoltaic cell (2) and a region where the electrode connection layer (112) is connected to the negative electrode of the photovoltaic cell (2) are located on two sides of the insulating groove (113).
